(19)

Europäisches
Patentamt
European
Patent Office
Office européen
des brevets

(11) **EP 1 826 864 A1**

(12) **EUROPEAN PATENT APPLICATION**

(43) Date of publication:
**29.08.2007 Bulletin 2007/35**

(51) Int Cl.:
**H01M 10/48** (2006.01)          *H01M 10/42* (2006.01)
**H01M 2/10** (2006.01)

(21) Application number: **07003360.0**

(22) Date of filing: **16.02.2007**

(84) Designated Contracting States:
**AT BE BG CH CY CZ DE DK EE ES FI FR GB GR
HU IE IS IT LI LT LU LV MC NL PL PT RO SE SI
SK TR**
Designated Extension States:
**AL BA HR MK YU**

(30) Priority: **23.02.2006 JP 2006046765**

(71) Applicant: **Sony Corporation
Minato-ku
Tokyo (JP)**

(72) Inventors:
• **Nakashima, Ryoichi
Minato-ku,
Tokyo (JP)**
• **Kumada, Masashi  c/o SONY EMCS
CORPORATION
Shinagawa-ku,
Tokyo (JP)**

• **Sato, Hideyuki
Minato-ku,
Tokyo (JP)**
• **Harada, Yoshio
Minato-ku,
Tokyo (JP)**
• **Kaneko, Michihiro
Minato-ku,
Tokyo (JP)**
• **Suzuki, Kentaro
Minato-ku,
Tokyo (JP)**

(74) Representative: **Müller - Hoffmann & Partner
Patentanwälte,
Innere Wiener Strasse 17
81667 München (DE)**

(54)    **Battery device and electronic equipment**

(57)    A battery device includes: a battery cell; a case that accommodates the battery cell; a battery side positive terminal and a battery side negative terminal provided in the case and electrically connected to the battery cell; a battery side communication terminal provided in the case; a battery side communication unit accommodated in the case and communicating with electronic equipment via the battery side communication terminal, the battery side communication unit provided under a changeable communication condition; and a battery side discrimination terminal provided in the case; a battery side control unit accommodated in the case, discriminating a magnitude of a voltage of the battery side discrimination terminal, and changing the communication condition based on a result of the discrimination.

FIG. 1

**EP 1 826 864 A1**

**Description**

CROSS REFERENCES TO RELATED APPLICATIONS

The present invention contains subject matter related to Japanese Patent Application JP 2006-046765 filed in the Japanese Patent Office on February 23, 2006, the entire contents of which being incorporated herein by reference.

BACKGROUND OF THE INVENTION

1. Field of the Invention

The present invention relates to a battery device and electronic equipment to which the battery device is attached.

2. Background Art

In portable electronic equipment such as a cellular phone, digital still camera, and video camera, a battery device (battery pack) is used as a power supply.

Recently, a battery device provided with a communication unit that conducts communication between electronic equipment and itself for transmitting remaining battery charge data of the battery device to the electronic equipment via the communication unit has been proposed (see JP-A-2005-345369 (patent document 1)).

In the battery device, not only a positive terminal and a negative terminal but also a communication terminal for serial communications is provided in a case containing a battery cell.

Because of the demand for the speeding up of the communication speed of the communication unit, it is conceivable that, as a battery device having such a communication unit, not only an existing battery device at a low communication speed but also a battery device at a high communication speed is manufactured.

In this case, not only existing electronic equipment capable of using only battery devices at low communication speeds but also electronic equipment capable of using a high-speed battery device is manufactured.

SUMMARY OF THE INVENTION

In the case where two kinds of battery devices of battery devices at low communication speeds and battery devices at high communication speeds are marketed, in electronic equipment at a low communication speed, only a battery device at a low communication speed is available, but a battery device at a high communication speed is not available. It is inconvenient for a user of the electronic equipment at a low communication speed because the user is unable to use the battery device at a high communication speed.

Accordingly, it is required to provide so-called upward compatibility to even electronic equipment at a low communication speed so that a battery device at a high communication speed may be available in the equipment.

In view of the above circumferences, it is desirable to provide a battery device that can be used even in electronic equipment under different communication conditions such as communication speeds by changing communication conditions of itself, and electronic equipment in which such a battery device is attached and used.

According to an embodiment of the invention, there is provided a battery device including: a battery cell; a case that accommodates the battery cell; a battery side positive terminal and a battery side negative terminal provided in the case and electrically connected to the battery cell; a battery side communication terminal provided in the case; a battery side communication unit accommodated in the case and communicating with electronic equipment via the battery side communication terminal, the battery side communication unit provided under a changeable communication condition; a battery side discrimination terminal provided in the case; a battery side control unit accommodated in the case, discriminating a magnitude of a voltage of the battery side discrimination terminal, and changing the communication condition based on a result of the discrimination.

Further, according to another embodiment of the invention, there is provided electronic equipment including: an attachment part to which a battery device is detachably attached, the attachment part provided with an equipment side positive terminal and an equipment side negative terminal connected to a battery side positive terminal and a battery side negative terminal provided in the battery device, respectively, and an equipment side communication terminal connected to a battery side communication terminal provided in the battery device; and an equipment side communication unit communicating with a communication unit of the battery device via the equipment side communication terminal, wherein an equipment side discrimination terminal connected to a battery side discrimination terminal is provided in the attachment part, the equipment side discrimination terminal is connected to a predetermined voltage.

According to a battery device of an embodiment of the invention, since the communication condition is changed based on the discrimination result of the magnitude of the voltage of the discrimination terminal, the device can be attached to electronic equipment under different communication conditions and used, which is advantageous in improvement of usability.

Further, according to electronic equipment of an embodiment of the invention, since the predetermined voltage is connected to the discrimination terminal connected to the discrimination terminal of the battery device, the battery device attached to the electronic equipment can change the communication condition based on the discrimination result of the magnitude of the voltage of the discrimination terminal and conduct communication, which is advantageous in improvement of usability.

BRIEF DESCRIPTION OF THE DRAWINGS

Fig. 1 is a perspective view of electronic equipment 10 and a battery device 30.
Fig. 2 is an explanatory diagram showing a state in which the battery device 30 is attached to the electronic equipment 10.
Fig. 3A is an explanatory diagram showing a configuration of the battery device 30.
Fig. 3B is a block diagram of the battery device 30.
Fig. 4 is a block diagram when the battery device 30 is attached to high-speed electronic equipment 10A.
Fig. 5 is a block diagram when the battery device 30 is attached to low-speed electronic equipment 10B.
Fig. 6 is an operation flowchart of the battery device 30.
Fig. 7 is a block diagram showing a state in which a low-speed battery device 64 is attached to low-speed electronic equipment 30B.
Fig. 8 is an explanatory diagram showing combinations of electronic equipment and battery devices.
Fig. 9A is a block diagram of a battery device 30 of the second embodiment.
Fig. 9B is an explanatory diagram of voltage E of a discrimination terminal 3408.
Fig. 10A is a block diagram showing a state in which first electronic equipment 70A is attached to the battery device 30.
Fig. 10B is an explanatory diagram of the voltage E of the discrimination terminal 3408.
Fig. 11A is a block diagram showing a state in which second electronic equipment 70B is attached to the battery device 30.
Fig. 11B is an explanatory diagram of the voltage E of the discrimination terminal 3408.
Fig. 12A is a block diagram showing a state in which third electronic equipment 70C is attached to the battery device 30.
Fig. 12B is an explanatory diagram of the voltage E of the discrimination terminal 3408.
Fig. 13A is a block diagram showing a state in which fourth electronic equipment 70D is attached to the battery device 30.
Fig. 13B is an explanatory diagram of the voltage E of the discrimination terminal 3408.

DESCRIPTION OF PREFERRED INVENTION

(First Embodiment)

Next, electronic equipment 10 and a battery device 30 according to an embodiment of the invention will be described with reference to the drawings.

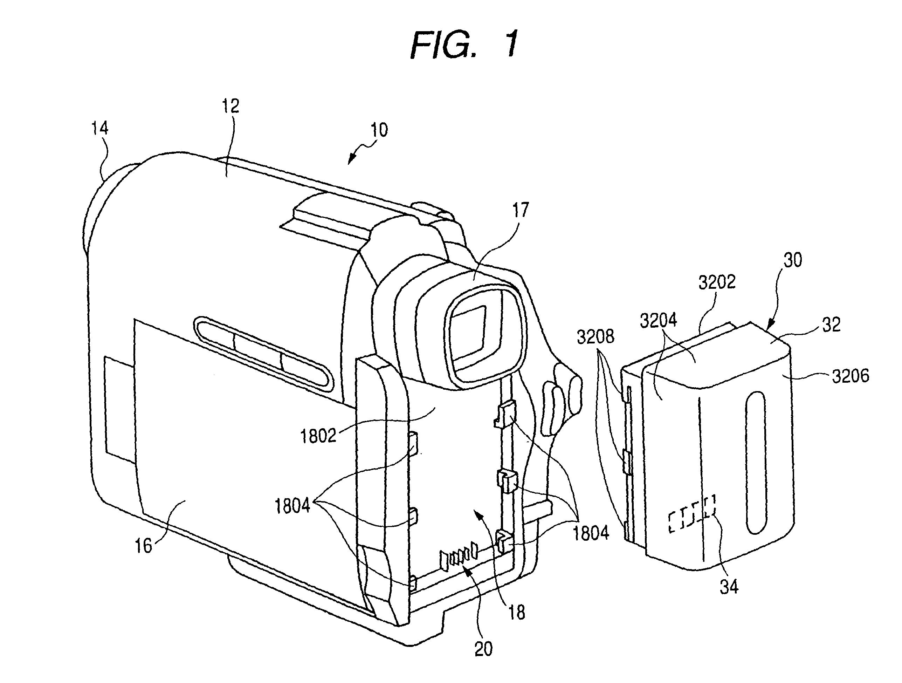

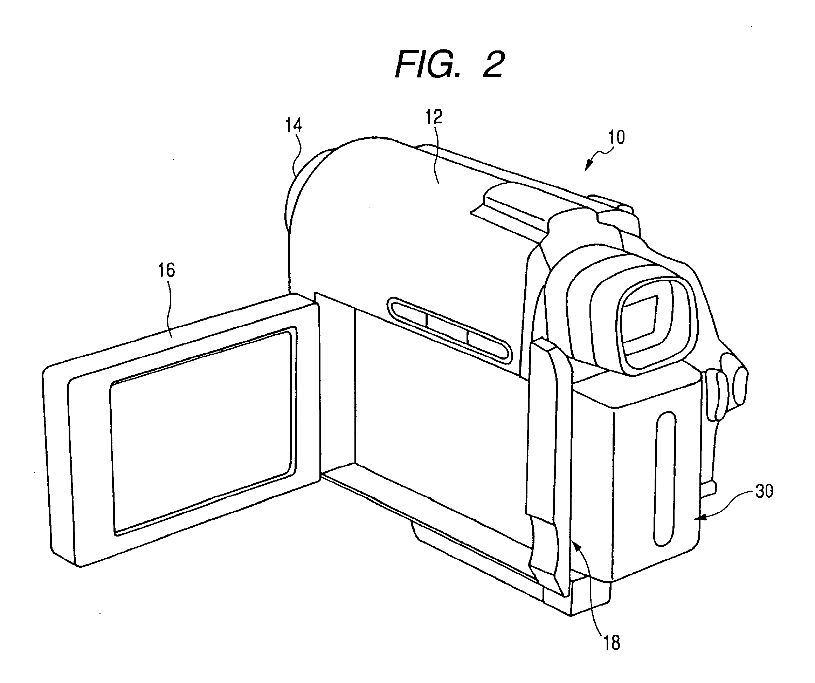

Fig. 1 is a perspective view of the electronic equipment 10 and the battery device 30, and Fig. 2 is an explanatory diagram showing a state in which the battery device 30 is attached to the electronic equipment 10.
In the embodiment, the electronic equipment 10 is an imaging apparatus as a video camera.
The electronic equipment 10 has a case 12, an optical system 14 incorporated into the front part of the case 12, an imaging device (not shown) that images a subject image captured by the optical system 14, a display 16 (corresponding to a display unit in claims) that displays images taken by the imaging device, and a recording and reproducing unit (not shown) that records in a recording medium and/or reproduces the images taken by the imaging device. The display 16 includes a liquid crystal display, for example.
A view finder device 17 is provided in the upper portion of the rear part of the case 12, and a battery attachment part 18 is provided under the view finder device 17.
The battery device 30 that supplies power to the imaging device, the display 16, the recording and reproducing unit, etc. is detachably attached to the battery attachment part 18.
The battery attachment part 18 has a flat attachment face 1802, plural latching pawls 1804 provided on the attachment face 1802, and an equipment side terminal 20.
Plural latching pawls 1804 are provided in both end positions in the width direction of the attachment face 1802.

The battery device 30 has a case 32, and the case 32 is in a rectangular parallelepiped having a bottom face 3202 in a rectangular shape, four side faces 3204 connected to four sides of the bottom face 3202, and an upper face 3206 connecting the side faces 3204.

A battery side terminal 34 to be connected to the equipment side terminal 20 is provided in a position near one short side of two short sides of the bottom face 3202.

Plural latch pieces 3208 capable of being latched by the latching pawls 1804 are provided in the two side faces 3204 respectively connected to two long sides of the bottom surface 3202.

When the battery side terminal 34 of the battery device 30 is allowed to face the equipment side terminal 20 of the battery attachment part 18, and the battery device 30 is slid downward in contact with the attachment face 1802, the respective latch pieces 3208 of the battery device 30 are latched by the latching pawls 1804, and the battery device 30 is attached to the battery attachment part 18 as shown in Fig. 2.

When the battery device 30 is attached to the battery attachment part 18, the battery side terminal 34 and the equipment side terminal 20 are connected to each other.

Next, the battery device 30 will be described in detail.

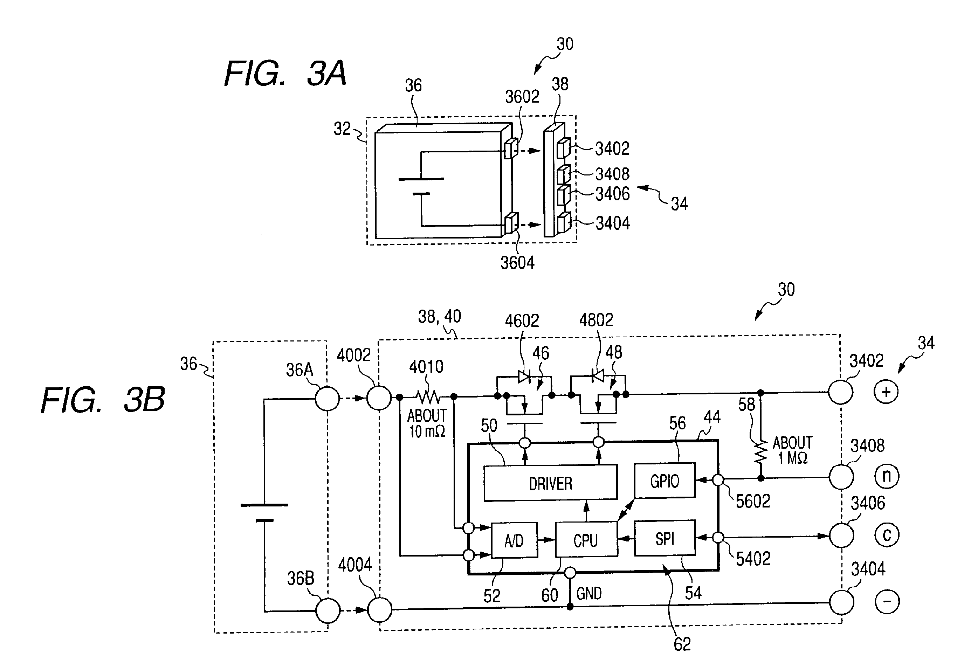

Fig. 3A is an explanatory diagram showing a configuration of the battery device 30, and Fig. 3B is a block diagram of the battery device 30.

As shown in Fig. 3A, the battery device 30 has a battery cell 36 and a control board 38, and the battery cell 36 and the control board 38 are accommodated in the case 32.

The battery cell 36 includes a secondary cell, a lithium-ion cell in a rectangular plate shape in the embodiment. As the secondary cell, any cell such as a nickel-cadmium cell or a nickel-hydride cell may be adopted.

A positive cell terminal 36A and a negative cell terminal 36B are provided on one side face of the battery cell 36.

The control board 38 is in a band plate shape and held in the case 32 with the rear face thereof overlapped with the one face of the battery cell 36.

The rear face of the control board 38 is electrically connected to the cell terminals 36A and 36B.

The battery side terminal 34 is provided on the front face of the control board 38.

The battery side terminal 34 has a positive terminal 3402, a negative terminal 3404, a communication terminal 3406, and a discrimination terminal 3408, and these four terminals are provided at intervals in the longitudinal direction of the control board 38 and these four terminals are provided to be exposed outward from an opening provided in the case 32.

Plural electronic components are mounted on the control board 38 and a control unit 40 is configured by them.

As shown in Fig. 3B, the control unit 40 includes a microcomputer 44, a charge FET 46, and a discharge FET 48, has a function of preventing overcharge and over discharge of the battery cell 36 thereby protecting the battery cell 36, and is designed according to independent electrical characteristics (specifications) of the battery cell 36.

The positive cell terminal 36A of the battery cell 36 is electrically connected to the positive terminal 3402 via a terminal 4002 and the serially connected charge FET 46 and discharge FET 48 and connected to the microcomputer 44.

The negative terminal 36B of the battery cell 36 is electrically connected to the negative terminal 3404 via a terminal 4004 and connected to the microcomputer 44.

In the detailed description, the cell terminal 36A is connected to the source of the charge FET 46 via the terminal 4002 of the control unit 40 and a sensing resistance 4010 of about several tens of milliohms, the drain of the charge FET 46 is connected to the source of the discharge FET 48, and the drain of the discharge FET 48 is connected to the positive terminal 3402.

A body diode (additional diode) 4602 is formed between the source and drain of the charge FET 46, and similarly, a body diode (additional diode) 4802 is formed between the source and drain of the discharge FET 48.

Drive signals supplied from a driver 50 of the control unit 40, which will be describe later, are provided to the gate of the charge FET 46 and the gate of the discharge FET 48, and thereby, on/off operation of the charge FET 46 and the discharge FET 48 is controlled.

A switch unit that turns on/off the electrical connection between the battery cell 36 and the positive terminals 3402 and 20B is configured by the charge FET 46 and the discharge FET 48. The switch unit is not limited to FETs, but may be any unit having a function of turning on/off the electrical connection between the battery cell 36 and the positive terminals 3402 and 20B.

The microcomputer 44 includes the driver 50, an A/D converter 52, a communication interface 54, an input/output interface 56, a CPU 60, etc.

The driver 50 supplies drive signals to the gates of the charge FET 46 and discharge FET 48 under the control of the CPU 60.

The A/D converter 52 supplies electrical potential difference value E corresponding to current supplied from the battery cell 36 or current supplied to the battery cell 36 by measuring the electrical potential difference between ends of the sensing resistance 4010 to the CPU 60, and the electrical potential difference value E is converted into the detected current of the battery cell 36 in the CPU 60.

The communication interface 54 is an interface used when the CPU 60 interactively communicates with the external electronic equipment 10 via the communication terminal 3406, and configured by a heretofore known serial peripheral interface (SPI) in the embodiment. The communication interface 54 is connected to the communication terminal 3406 via a communication terminal 5402 of the microcomputer 44.

Thus, a communication unit 62 that communicates with the electronic equipment 10 is configured by the CPU 60 and the communication interface 54 in the embodiment.

The communication unit 62 is configured so that the communication speed as a communication condition can be changed, and the communication unit 62 is configured to be switched between two communication speeds of a high speed (4X (8192 pbs)) and a low speed (1X (2048 pbs)).

The input/output interface 56 has plural input ports and output ports, and one input port 5602 of them is connected to the discrimination terminal 3408.

In the embodiment, one end of a resistance 58 of about 1 MΩ is connected to the positive terminal 3402, the other end thereof is connected to the discrimination terminal 3408, and the voltage of the other end of the resistance 58 is supplied to the input port 5602.

Therefore, the input port 5602 and the discrimination terminal 3408 are pulled up to the output voltage of the battery cell 36, i.e., "H" level via the resistance 58.

The CPU 60 operates when programs stored in a ROM (not shown) are executed, controls the driver 50, the A/D converter 52, the communication interface 54, and the input/output interface 56, and operates by the direct-current power supplied via the cell terminals 36A and 36B of the battery cell 36.

Further, the CPU 60 monitors the detected current of the battery cell 36 detected by the A/D converter 52. At the time of charging, the CPU prevents overcharge of the battery cell 36 by turning off the charge FET 46 in response to the value of the detected current, and further, at the time of discharging, the CPU prevents over discharge of the battery cell 36 or overcurrent when the positive terminal 3402 and the negative terminal 3404 short-circuit by turning off the discharge FET 48 in response to the value of the detected current.

Further, the CPU 60 is configured to detect the remaining charge of the battery cell 36 based on the detected current of the battery cell 36 and transmit the remaining charge data to the electronic equipment 10 via the communication unit 62.

Further, the CPU 60 is configured to discriminate the magnitude of the voltage of the discrimination terminal 3408 via the input/output interface 56 and change the communication speed of the communication unit 62 based on the discrimination result thereof.

In the embodiment, when the discrimination terminal 3408 is opened, the other end of the resistance 58 reaches "H" level, and, when the discrimination terminal 3408 is connected to the ground level, the other end of the resistance 58 reaches "L" level.

The CPU 60 is configured to change the communication speed of the communication unit 62 to the low speed if the discrimination terminal 3408 is at "H" level, and to change the communication speed of the communication unit 62 to the high speed if the discrimination terminal 3408 is at "L" level.

The battery device 30 is configured to be available in both the electronic equipment 10 at the high communication speed (4X (8192 pbs)) and the electronic equipment 10 at the low communication speed (1X (2048 pbs)).

As below, the cases where the battery device 30 is attached to the electronic equipment 10A at the high communication speed (hereinafter, referred to high-speed electronic equipment 10A) and to the electronic equipment 10B at the low communication speed (hereinafter, referred to a low-speed electronic equipment 10B) will be described.

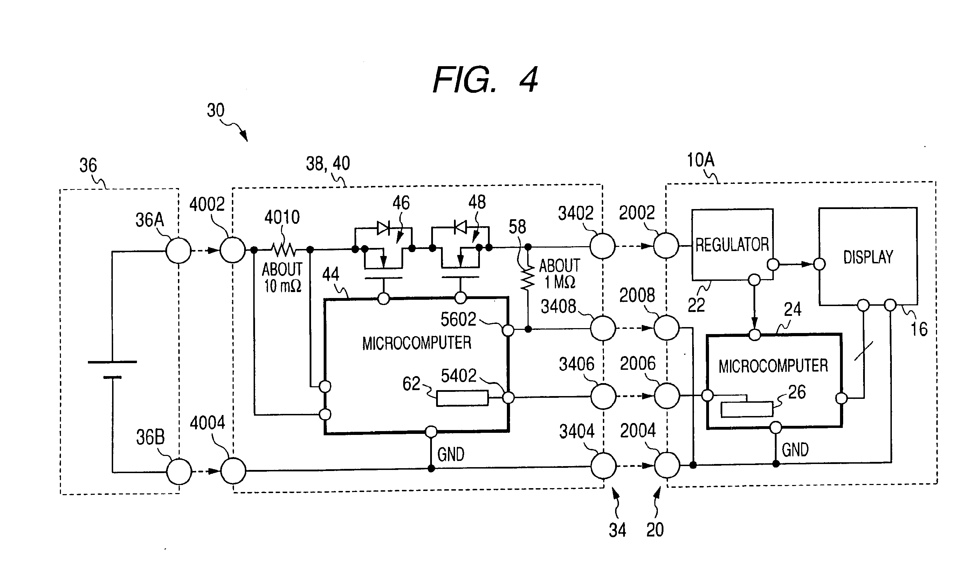

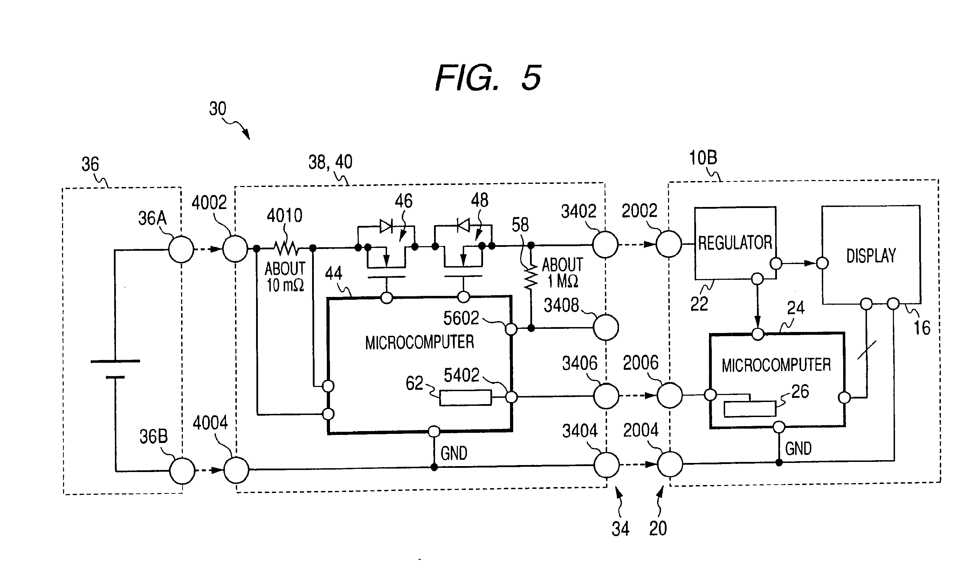

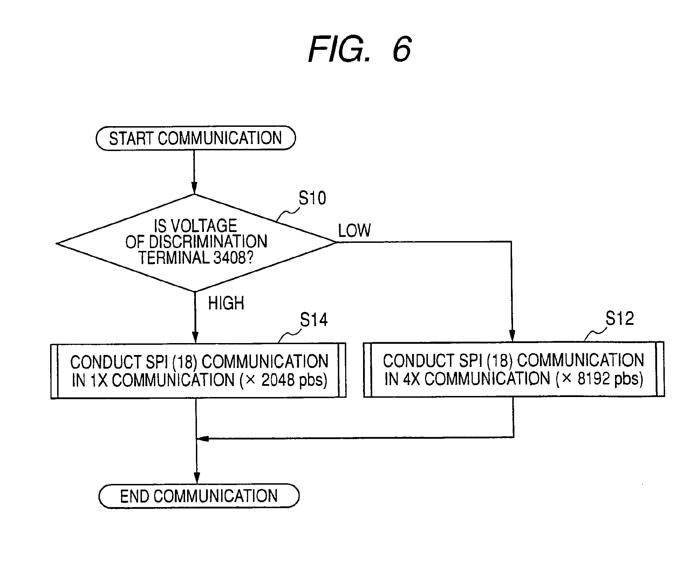

Fig. 4 is a block diagram when the battery device 30 is attached to the high-speed electronic equipment 10A, Fig. 5 is a block diagram when the battery device 30 is attached to the low-speed electronic equipment 10B, and Fig. 6 is an operation flowchart of the battery device 30.

First, the configuration of the high-speed electronic equipment 10A will be described by referring to Fig. 4.

In the high-speed electronic equipment 10A, the equipment side terminal 20 has four terminals of a positive terminal 2002, a negative terminal 2004, a communication terminal 2006, and a discrimination terminal 2008.

When the battery device 30 is attached to the battery attachment part 18, the positive terminal 2002, the negative terminal 2004, the communication terminal 2006, and the discrimination terminal 2008 are connected to the positive terminal 3402, the negative terminal 3404, the communication terminal 3406, and the discrimination terminal 3408 of the battery device 30, respectively.

The high-speed electronic equipment 10A includes a regulator 22 and a microcomputer 24 in addition to the above described display 16.

The regulator 22 stabilizes the power to be supplied from the battery device 30 via the positive terminal 2002 and the negative terminal 2004 into a predetermined voltage or predetermined current and supplies it to the display 16, the microcomputer 24, the imaging device, and the recording and reproducing unit.

The microcomputer 24 includes a communication unit 26 with a CPU and a communication interface (not shown), and the communication unit 26 is configured to conduct serial communication at a high communication speed with the communication unit 62 of the battery device 30 via the communication terminals 2006 and 3406.

The discrimination terminal 2008 is connected to a predetermined voltage, the ground level in the embodiment. Accordingly, when the battery device 30 is attached to the battery attachment part 18, the discrimination terminal 3408 of the battery device 30 is connected to the ground level via the discrimination terminal 2008 of the high-speed electronic equipment 10A, and thus, the voltage of the discrimination terminal 3408 is at "L" level.

Next, the configuration of the low-speed electronic equipment 10B will be described by referring to Fig. 5.

The low-speed electronic equipment 10B is different from the high-speed electronic equipment 10A in the point where the equipment side terminal 20 has three terminals of a positive terminal 2002, a negative terminal 2004, and a communication terminal 2006, but a discrimination terminal 2008 is not provided.

When the battery device 30 is attached to the battery attachment part 18, the positive terminal 2002, the negative terminal 2004, and the communication terminal 2006 are connected to the positive terminal 3402, the negative terminal 3404, and the communication terminal 3406 of the battery device 30, respectively.

The low-speed electronic equipment 10B includes a regulator 22 and a microcomputer 24 in addition to the display 16 similarly to the high-speed electronic equipment 10A.

The microcomputer 24 includes a communication unit 26 with a CPU and a communication interface (not shown), and the communication unit 26 is configured to conduct serial communication at a low communication speed with the communication unit 62 of the battery device 30 via the communication terminals 2006 and 3406.

Since the discrimination terminal 2008 is not provided in the low-speed electronic equipment 10B, when the battery device 30 is attached to the battery attachment part 18, the discrimination terminal 3408 of the battery device 30 is in an open state, and thus, the voltage of the discrimination terminal 3408 pulled up by the resistance 58 is at "H" level.

Next, the operation of the battery device 30 will be described by referring to Fig. 6.

When the battery device 30 is attached to the battery attachment part 18 and the positive terminal 3402 and the negative terminal 3404 of the battery side terminal 34 are connected to the positive terminal 2002 and the negative terminal 2004 of the equipment side terminal 20, current flows via the sensing resistance 4010. The CPU 60 starts communication operation on detecting the current.

The CPU 60 discriminates whether the voltage of the discrimination terminal 3408 is at "H" level or "L" level via the input port 5602 (step S10).

If the voltage is discriminated to be at "L" level, the CPU 60 determines that the electronic equipment 10 to which the battery device 30 is attached is a high-speed electronic equipment 10A, changes the communication speed of the communication unit 62 to the high speed and allows communication, transmits the remaining charge data of the battery cell 36 to the high-speed electronic equipment 10A (step S12), and ends the communication.

Thereby, the CPU of the high-speed electronic equipment 10A displays the remaining charge on the display 16 based on the remaining charge data received by the communication unit 26.

On the other hand, if the voltage is discriminated to be at "H" level in step S10, the CPU 60 determines that the electronic equipment 10 to which the battery device 30 is attached is a low-speed electronic equipment 10B, changes the communication speed of the communication unit 62 to the low speed and allows communication, transmits the remaining charge data of the battery cell 36 to the low-speed electronic equipment 10B (step S14), and ends the communication.

Thereby, the CPU of the low-speed electronic equipment 10B displays the remaining charge on the display 16 based on the remaining charge data received by the communication unit 26.

Next, the case where a battery device 64 that communicates at a low speed (hereinafter, referred to as a low-speed battery device 64) is attached to a low-speed electronic equipment 30B will be described.

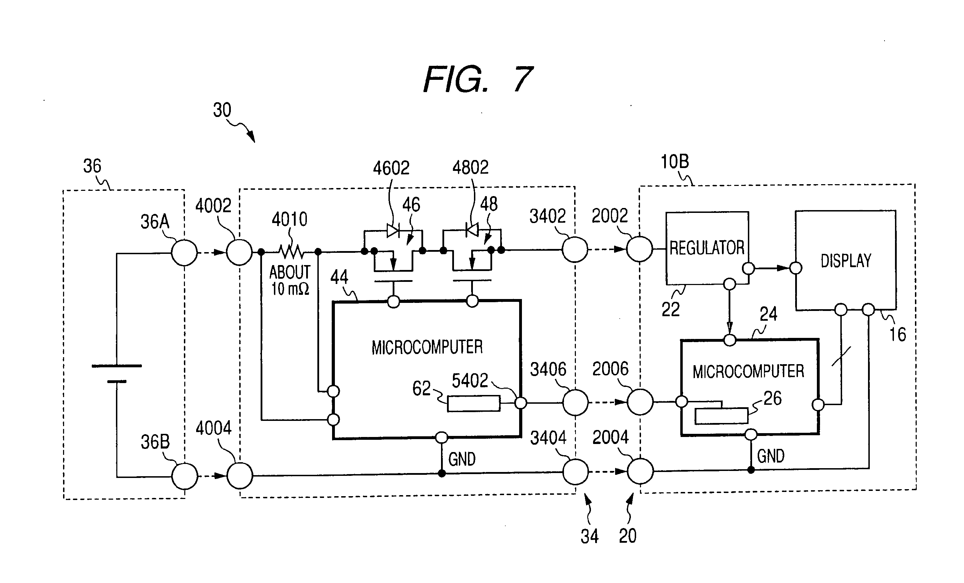

Fig. 7 is a block diagram showing a state in which the low-speed battery device 64 is attached to the low-speed electronic equipment 30B.

The low-speed battery device 64 is different from the battery device 30 in the point where the device 64 does not have a discrimination terminal 3408 or a resistance 58, and the other constitution is the same as that of the battery device 30.

In this case, when the low-speed battery device 64 is attached to the battery attachment part 18, the positive terminal 2002, the negative terminal 2004, and the communication terminal 2006 are connected to the positive terminal 3402, the negative terminal 3404, and the communication terminal 3406 of the low-speed battery device 64, respectively.

The communication unit 26 of the microcomputer 24 is configured to conduct serial communication at a low communication speed with the communication unit 62 of the low-speed battery device 64 via the communication terminals 2006 and 3406.

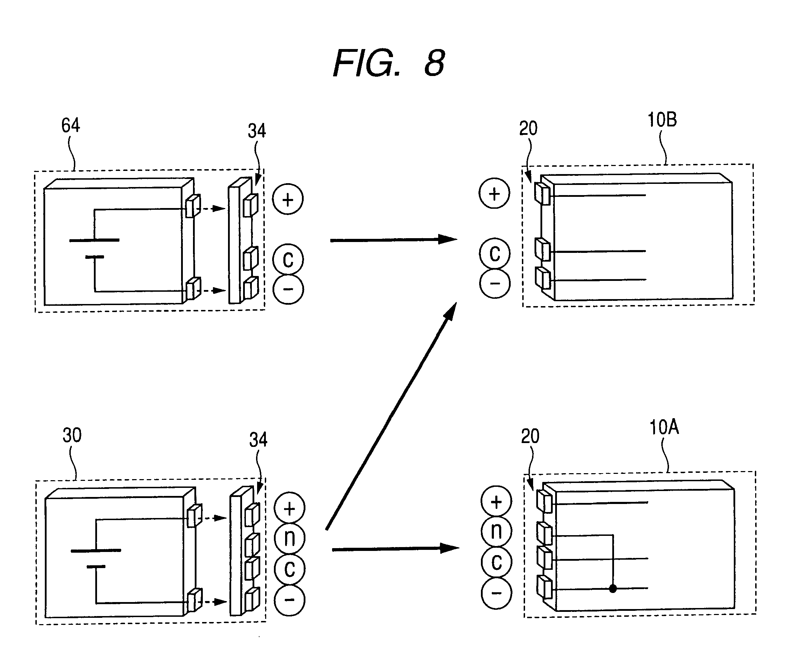

Fig. 8 is an explanatory diagram showing combinations of electronic equipment and battery devices.

In Fig. 8, the sign "+" indicates a positive terminal, the sign "-" indicates a negative terminal, the sign "c" indicates a communication terminal, and the sign "n" indicates a discrimination terminal. Further, the arrows depicted from the battery devices to the electronic equipment indicate that the battery devices are able to be attached to the electronic equipment and used.

As described above, the battery device 30 according to an embodiment of the invention is able to be attached to both the high-speed electronic equipment 10A and the low-speed electronic equipment 10B and used and realize the so-called upward compatibility by changing the communication speed.

On the other hand, the communication speed of the low-speed battery device 64 is fixed and unchangeable, and thus, the device is able to be attached to the low-speed electronic equipment 10B and used, but unable to be used even when attached to the high-speed electronic equipment 10A.

Therefore, it is preferable that the low-speed battery device 64 is made unable to be attached to the attachment part 18 of the high-speed electronic equipment 10A by arranging the low-speed battery device 64 as below.

That is, a projecting portion is provided on the attachment part 18 of the high-speed electronic equipment 10A and a recessed portion that receives the projecting portion is provided on the case 32 of the battery device 30.

The projecting portion is not provided on the attachment part 18 of the low-speed electronic equipment 10B or the recessed portion is not provided on the case of the low-speed battery device 64.

By the arrangement, since the projecting portion is provided on the attachment part 18 of the high-speed electronic equipment 10A, the battery device 30 with the recessed portion can be attached, but the low-speed battery device 64 without the recessed portion is unable to be attached thereto.

On the other hand, since the projecting portion is not provided on the attachment part 18 of the low-speed electronic equipment 10B, both the battery device 30 with the recessed portion and the low-speed battery device 64 without the recessed portion are able to be attached thereto.

According to the battery device 30 of the embodiment, since the device has the discrimination terminal 3408 and changes the communication speed as a communication condition of the communication unit 62 based on the discrimination result of the magnitude of the voltage of the discrimination terminal 3408, the device can be attached to electronic equipment at different communication speeds and used, which is advantageous in improvement of usability.

Further, according to the electronic equipment 10 of the embodiment, since the equipment has the discrimination terminal 2008 to be connected to the discrimination terminal 3408 and a predetermined voltage is connected to the discrimination terminal 2008, the battery device 30 attached to the electronic equipment 10 is able to change the communication speed as a communication condition of the communication unit 62 based on the discrimination result of the magnitude of the voltage of the discrimination terminal 3408, which is advantageous in improvement of usability.

Further, according to the battery device 30 and the electronic equipment 10 of the embodiment, the communication speed is changed based on the discrimination result of the magnitude of the voltage of the discrimination terminal 3408, and there are advantages that the time necessary for determining the communication speed is short and shortening of the time from attachment of the battery device 30 to the electronic equipment 10 till reception of necessary data can be realized.

Specifically, when the remaining charge data of the battery is transmitted from the battery device 30 to the electronic equipment 10 and the electronic equipment 10 is allowed to display the remaining charge, there is an advantage in that shortening of the time from attachment of the battery device 30 to the electronic equipment 10 till display of remaining charge can be realized.

For example, when the communication speed is determined between the battery device 30 and the electronic equipment 10, first, compared to the case where the communication speed is confirmed by handshake communication at a low communication speed and then the communication speed is changed, such communication for determining the communication speed is not necessary in the embodiment, which is advantageous in significant reduction of time.

Further, in order to conduct the communication for determining the communication speed, the configuration of the software regarding the communication control of both the battery device 30 and the electronic equipment 10 becomes complex and disadvantageous in reduction of costs, however, the embodiment is advantageous in that such software can be simplified.

Further, according to the battery device 30 of the embodiment, facilities (adjustment apparatus and inspection apparatus) for communication via the communication terminal 3406 of the battery device 30 in adjustment and inspection at factory shipment may be facilities at lower communication speeds. Therefore, the battery device 30 can be manufactured without newly adding a facility capable of high-speed communication as the facilities, which is advantageous in suppression of manufacturing costs.

(Second Embodiment)

Next, the second embodiment will be described.

The second embodiment is different from the first embodiment in the point where the communication condition includes two kinds of communication formats in addition to two communication speeds and the voltage of the discrimination terminal 3408 is discriminated in four levels. The communication formats include protocols in the embodiment.

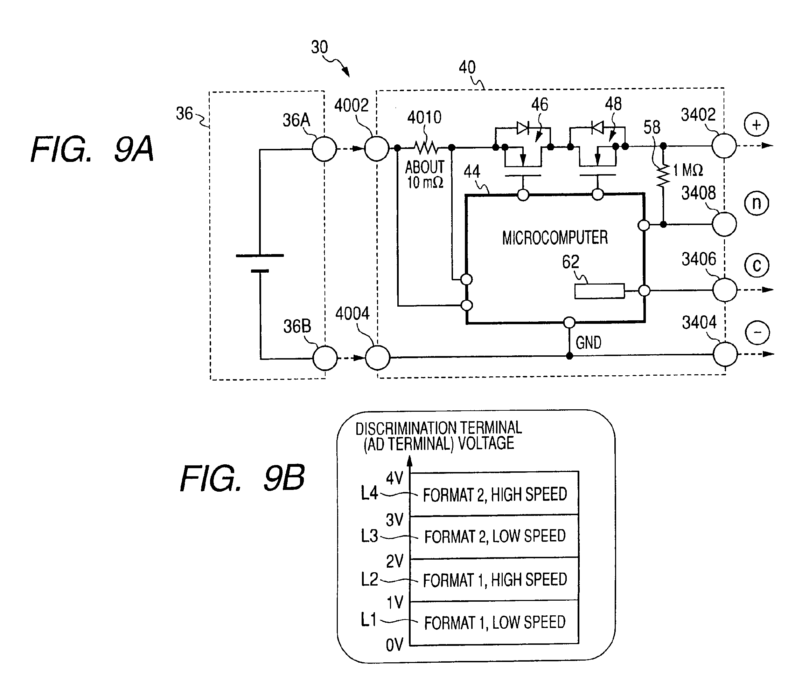

Fig. 9A is a block diagram of the battery device 30 of the second embodiment, Fig. 9B is an explanatory diagram of the voltage of the discrimination terminal 3408. In the embodiment, the same signs will be assigned to the same or similar parts and members as those in the first embodiment and described.

As shown in Fig. 9A, the configuration of the battery device 30 is the same as that in the first embodiment.

As shown in Fig. 9B, the communication unit 62 is able to change the communication speed as a communication condition to two levels of a high speed and a low speed, and able to change the communication format as a communication condition to two kinds of Format 1 and Format 2 in the respective communication speeds. The unit is configured to change four kinds of communication conditions by combining them.

Further, the CPU 60 (see Fig. 3) is configured to discriminate voltage E of the discrimination terminal 3408 in voltage ranges of the four levels.

That is, when the voltage of the positive terminal 3402 is 4 V, the first voltage range L1 is from 0 V to less than 1 V, the second voltage range L2 is from 1 V to less than 2 V, the third voltage range L3 is from 2 V to less than 3 V, the fourth voltage range L4 is from 3 V to 4 V.

If the voltage E of the discrimination terminal 3408 falls within the first voltage range L1, the CPU 60 changes the communication speed to the low speed and changes the communication format to Format 1.

If the voltage E of the discrimination terminal 3408 falls within the second voltage range L2, the CPU 60 changes the communication speed to the high speed and changes the communication format to Format 1.

If the voltage E of the discrimination terminal 3408 falls within the third voltage range L3, the CPU 60 changes the communication speed to the low speed and changes the communication format to Format 2.

If the voltage E of the discrimination terminal 3408 falls within the fourth voltage range L4, the CPU 60 changes the communication speed to the high speed and changes the communication format to Format 2.

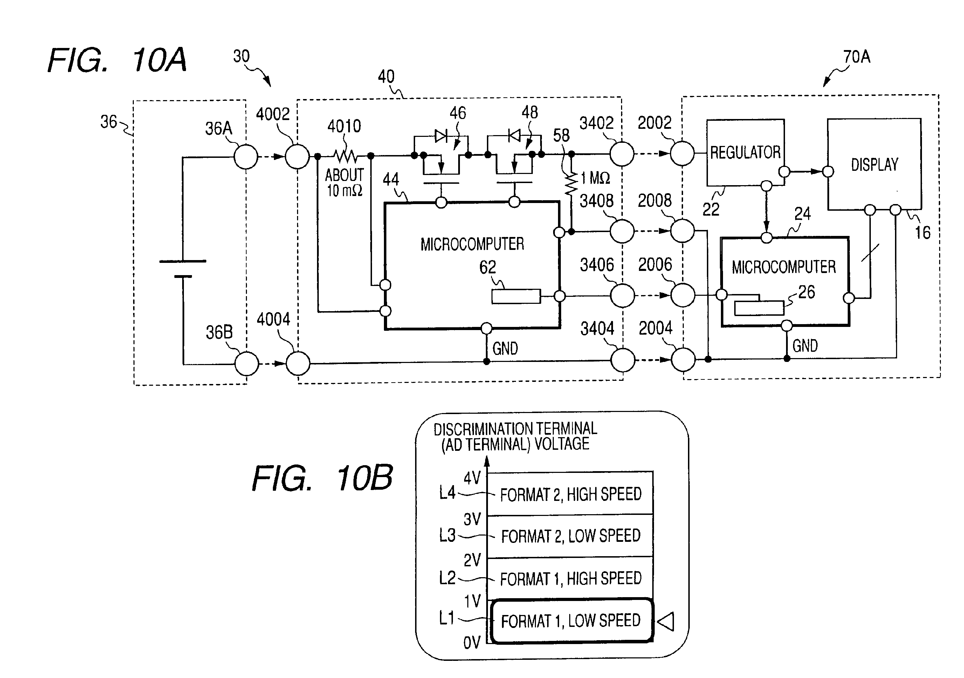

Fig. 10A is a block diagram showing a state in which first electronic equipment 70A is attached to the battery device 30, and Fig. 10B is an explanatory diagram of the voltage E of the discrimination terminal 3408.

The discrimination terminal 2008 of the first electronic equipment 70A is connected to the ground level (a predetermined voltage).

Accordingly, when the battery device 30 is attached to the first electronic equipment 70A, the voltage E of the discrimination terminal 3408 of the battery device 30 is 0 V within the first voltage range L1, and thus, the CPU 60 changes the communication speed of the communication unit 62 to the low speed and changes the communication format to Format 1.

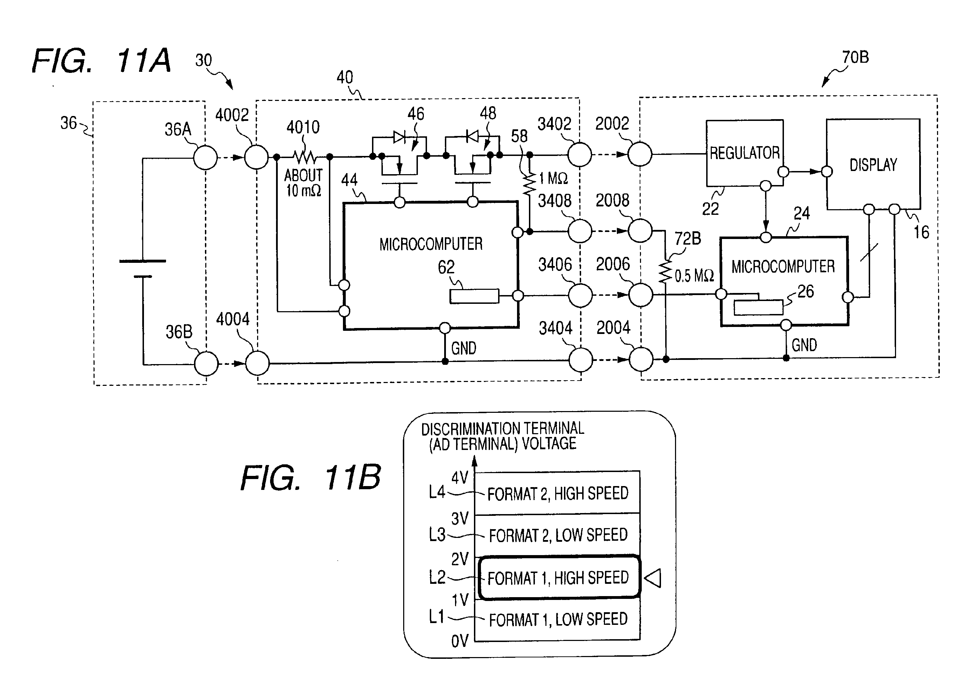

Fig. 11A is a block diagram showing a state in which second electronic equipment 70B is attached to the battery device 30, and Fig. 11B is an explanatory diagram of the voltage E of the discrimination terminal 3408.

The discrimination terminal 2008 of the second electronic equipment 70B is connected to the ground level (a predetermined voltage) via a resistance 72B (0.5 MΩ).

When the battery device 30 is attached to the second electronic equipment 70B, the voltage of 4V is divided by the resistance 58 (resistance of 1 MΩ) and the resistance 72B (0.5 MΩ).

That is, the voltage E of the discrimination terminal 3408 of the battery device 30 is

$$E = 4 \text{ V} \times 0.5/(0.5 + 1) = 1.3 \text{ V}$$

and the voltage E falls within the second voltage range L2, and thus, the CPU 60 changes the communication speed of the communication unit 62 to the high speed and changes the communication format to Format 1.

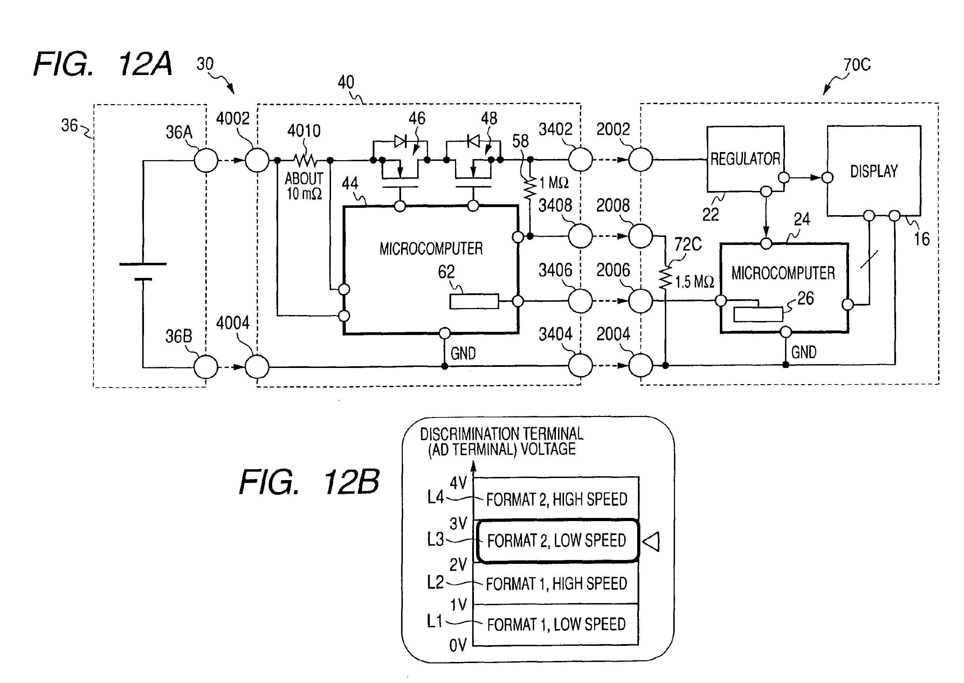

Fig. 12A is a block diagram showing a state in which third electronic equipment 70C is attached to the battery device 30, and Fig. 12B is an explanatory diagram of the voltage E of the discrimination terminal 3408.

The discrimination terminal 2008 of the third electronic equipment 70C is connected to the ground level (a predetermined voltage) via a resistance 72C (1.5 MΩ).

When the battery device 30 is attached to the third electronic equipment 70C, the voltage of 4V is divided by the resistance 58 (resistance of 1 MΩ) and the resistance 72C (1.5 MΩ).

That is, the voltage E of the discrimination terminal 3408 of the battery device 30 is

$$E = 4 \text{ V} \times 1.5/(1.5 + 1) = 2.4 \text{ V}$$

and the voltage E falls within the third voltage range L3, and thus, the CPU 60 changes the communication speed of the communication unit 62 to the low speed and changes the communication format to Format 2.

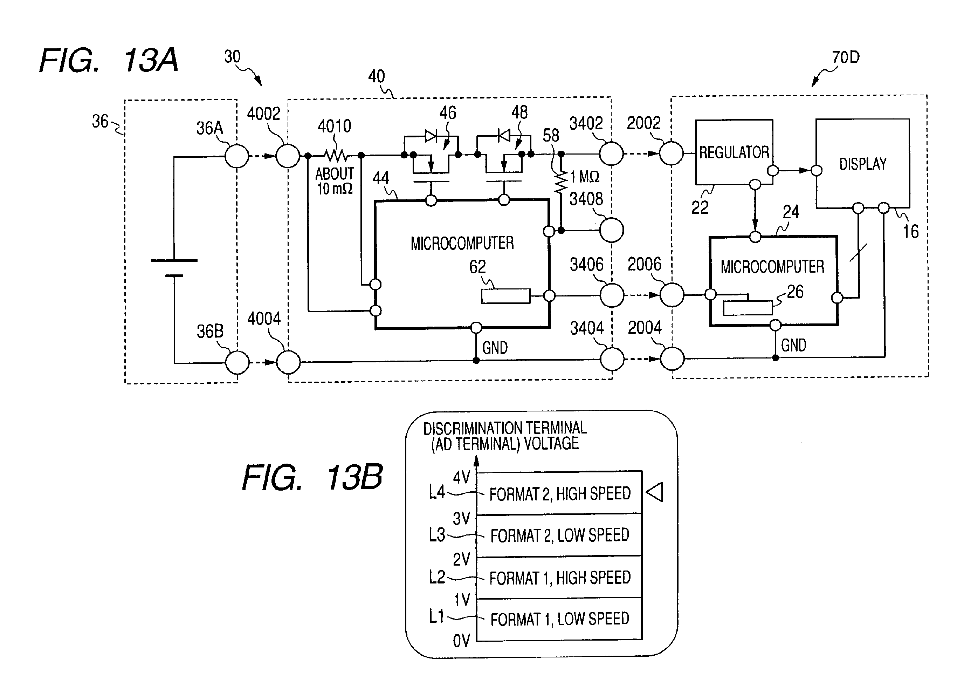

Fig. 13A is a block diagram showing a state in which fourth electronic equipment 70D is attached to the battery device 30, and Fig. 13B is an explanatory diagram of the voltage E of the discrimination terminal 3408.

The discrimination terminal 2008 is not provided to the fourth electronic equipment 70D.

When the battery device 30 is attached to the fourth electronic equipment 70D, the discrimination terminal 3408 is in an open state.

Accordingly, the voltage E of the discrimination terminal 3408 pulled up by the resistance 58 is 4 V, and the voltage E falls within the fourth voltage range L4, and thus, the CPU 60 changes the communication speed of the communication unit 62 to the high speed and changes the communication format to Format 2.

According to the embodiment, regardless to add, the same effects as those of the first embodiment can be exerted and not only the communication speed but also the communication format can be changed and the device is able to be attached to electronic equipment in different communication formats, which is advantageous in improvement of usability.

Further, in the embodiment, the battery device 30 has the resistance 58 with one end connected to the positive terminal 3402 and the other end connected to the discrimination terminal 3408, and the discrimination terminals 2008 of the electronic equipment 70B and 70C are connected to a predetermined voltage (the ground level) via the resistances 72B and 72C.

Therefore, the configuration of the electronic equipment can be simplified because the voltage E of the discrimination terminal 3408 of the battery device 30 is able to be formed by the simple configuration of dividing the positive terminal of the battery device 30 by the resistance 58 of the battery device 30 and the resistances 72B and 72C of the electronic equipment, which is advantageous in reduction of costs.

Although the case where the communication units of the electronic equipment and the battery device communicate in serial communication with each other has been described in the embodiment, as long as the communication units of the electronic equipment and the battery device are able to communicate with each other, the communication system of them is not limited to the serial communication but may be parallel communication.

Further, although the case where the electronic equipment is an imaging apparatus has been described in the embodiment, the electronic equipment is not limited to imaging apparatuses such as a video camera and digital still camera, but widely applied to various kinds of portable electronic equipment.

It should be understood by those skilled in the art that various modifications, combinations, sub-combinations and alterations may occur depending on design requirements and other factors insofar as they are within the scope of the appended claims or the equivalents thereof.

**Claims**

1.    A battery device comprising:

>    a battery cell;
>    a case that accommodates the battery cell;
>    a battery side positive terminal and a battery side negative terminal provided in the case and electrically connected to the battery cell;
>    a battery side communication terminal provided in the case;
>    a battery side communication unit accommodated in the case and communicating with electronic equipment via the battery side communication terminal, the battery side communication unit provided under a changeable communication condition;
>    a battery side discrimination terminal provided in the case; and
>    a battery side control unit accommodated in the case, discriminating a magnitude of a voltage of the battery side discrimination terminal, and changing the communication condition based on a result of the discrimination.

2.    The battery device according to claim 1, wherein the communication condition includes one or both of a communication speed and a communication format.

3.    The battery device according to claim 1, wherein the battery side control unit has a resistance with one end connected to the battery side positive terminal and the other end connected to the battery side discrimination terminal, and the discrimination by the battery side control unit is made based on a voltage of the other end of the resistance.

4.    The battery device according to claim 1, wherein the communication by the battery side communication unit is serial communication.

5.    The battery device according to claim 1, wherein the battery side control unit is configured to detect remaining charge of the battery cell, and the battery side communication unit is configured to communicate data representing the remaining charge of the battery cell to the electronic equipment.

6. Electronic equipment comprising:

an attachment part to which a battery device is detachably attached, and
the attachment part provided with an equipment side positive terminal and an equipment side negative terminal connected to a battery side positive terminal and a battery side negative terminal provided in the battery device, respectively, and an equipment side communication terminal connected to a battery side communication terminal provided in the battery device; and
an equipment side communication unit communicating with a communication unit of the battery device via the equipment side communication terminal,
wherein an equipment side discrimination terminal connected to a battery side discrimination terminal is provided in the attachment part,
and the equipment side discrimination terminal is connected to a predetermined voltage.

7. The electronic equipment according to claim 6, wherein the connection of the equipment side discrimination terminal to the predetermined voltage is made via a resistance.

8. The electronic equipment according to claim 6, wherein the predetermined voltage is the ground level.

9. The electronic equipment according to claim 6, wherein the communication is serial communication.

10. The electronic equipment according to claim 6, further comprising a display unit and an equipment side control unit, wherein the equipment side communication unit receives remaining charge of the battery device received from the communication unit of the battery device via the equipment side communication terminal, and
the equipment side control unit allows the display unit to display remaining charge corresponding to the remaining charge of the battery device received by the equipment side communication unit.

FIG. 1

EP 1 826 864 A1

FIG. 2

EP 1 826 864 A1

EP 1 826 864 A1

FIG. 3A

FIG. 3B

# FIG. 4

EP 1 826 864 A1

FIG. 5

# FIG. 6

```
          ┌─────────────────────────┐
          │   START COMMUNICATION   │
          └─────────────────────────┘
                      │
                      ▼
                                    S10
               ╱ IS VOLTAGE  ╲      LOW
              ╱ OF DISCRIMINATION╲─────────────┐
              ╲ TERMINAL 3408?  ╱              │
               ╲              ╱                │
                   │ HIGH                      │
                   │                           │
                   ▼  S14                      ▼  S12
    ┌──────────────────────────────┐  ┌──────────────────────────────┐
    │ CONDUCT SPI (18) COMMUNICATION│  │ CONDUCT SPI (18) COMMUNICATION│
    │ IN 1X COMMUNICATION (× 2048 pbs)│  │ IN 4X COMMUNICATION (× 8192 pbs)│
    └──────────────────────────────┘  └──────────────────────────────┘
                   │                           │
                   ◄───────────────────────────┘
                   │
                   ▼
          ┌─────────────────────────┐
          │    END COMMUNICATION    │
          └─────────────────────────┘
```

# FIG. 7

FIG. 8

FIG. 9A

FIG. 9B

FIG. 10A

FIG. 10B

DISCRIMINATION TERMINAL
(AD TERMINAL) VOLTAGE

| | |
|---|---|
| L4 — 4V | FORMAT 2, HIGH SPEED |
| L3 — 3V | FORMAT 2, LOW SPEED |
| L2 — 2V | FORMAT 1, HIGH SPEED |
| L1 — 1V | FORMAT 1, LOW SPEED |
| 0V | |

FIG. 11A

FIG. 11B

DISCRIMINATION TERMINAL
(AD TERMINAL) VOLTAGE

L4 — FORMAT 2, HIGH SPEED — 4V

L3 — FORMAT 2, LOW SPEED — 3V

L2 — FORMAT 1, HIGH SPEED — 2V

L1 — FORMAT 1, LOW SPEED — 1V

0V

EP 1 826 864 A1

# FIG. 12A

# FIG. 12B

FIG. 13A

FIG. 13B

DISCRIMINATION TERMINAL (AD TERMINAL) VOLTAGE

| | | |
|---|---|---|
| L4 | 4V | FORMAT 2, HIGH SPEED ◁ |
| L3 | 3V | FORMAT 2, LOW SPEED |
| L2 | 2V | FORMAT 1, HIGH SPEED |
| L1 | 1V | FORMAT 1, LOW SPEED |
| | 0V | |

EP 1 826 864 A1

**European Patent Office**

**EUROPEAN SEARCH REPORT**

Application Number

EP 07 00 3360

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 154 004 A (HIGUCHI YOSHINARI [JP]) 28 November 2000 (2000-11-28) * the whole document * ----- | 1-10 | INV. H01M10/48 ADD. H01M10/42 H01M2/10 |
| X | US 2001/005122 A1 (HIGUCHI YOSHINARI [JP]) 28 June 2001 (2001-06-28) * the whole document * ----- | 1-10 | |
| X | US 6 285 158 B1 (HIGUCHI YOSHINARI [JP]) 4 September 2001 (2001-09-04) * the whole document * ----- | 1-10 | |
| X | EP 1 178 547 A2 (SONY CORP [JP]) 6 February 2002 (2002-02-06) * the whole document * ----- | 1-10 | |
| X | US 5 783 998 A (NAKAJOU HIDEKI [JP] ET AL) 21 July 1998 (1998-07-21) * the whole document * ----- | 1-10 | |
| | | | TECHNICAL FIELDS SEARCHED (IPC) H01M |

The present search report has been drawn up for all claims

| Place of search | Date of completion of the search | Examiner |
|---|---|---|
| Munich | 12 June 2007 | Koessler, Jean-Luc |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 07 00 3360

This annex lists the patent family members relating to the patent documents cited in the above-mentioned European search report.
The members are as contained in the European Patent Office EDP file on
The European Patent Office is in no way liable for these particulars which are merely given for the purpose of information.

12-06-2007

| Patent document cited in search report | | Publication date | Patent family member(s) | | Publication date |
|---|---|---|---|---|---|
| US 6154004 | A | 28-11-2000 | CN | 1624964 A | 08-06-2005 |
| | | | DE | 69718081 D1 | 06-02-2003 |
| | | | DE | 69718081 T2 | 09-10-2003 |
| | | | DE | 69733325 D1 | 23-06-2005 |
| | | | DE | 69733325 T2 | 19-01-2006 |
| | | | EP | 0786821 A1 | 30-07-1997 |
| | | | JP | 9271144 A | 14-10-1997 |
| US 2001005122 | A1 | 28-06-2001 | NONE | | |
| US 6285158 | B1 | 04-09-2001 | US | 6291967 B1 | 18-09-2001 |
| EP 1178547 | A2 | 06-02-2002 | NONE | | |
| US 5783998 | A | 21-07-1998 | JP | 3649296 B2 | 18-05-2005 |
| | | | JP | 8308121 A | 22-11-1996 |

EPO FORM P0459

For more details about this annex : see Official Journal of the European Patent Office, No. 12/82

**EP 1 826 864 A1**

**REFERENCES CITED IN THE DESCRIPTION**

**Patent documents cited in the description**

- JP 2006046765 A

- JP 2005345369 A